# EUROPEAN PATENT APPLICATION

(11) **EP 3 260 895 A1**
(43) Date of publication of application: **27.12.2017**
(21) Application number: 15881899.7
(22) Date of filing: 16.12.2015
(51) Int. Cl.: G02B 5/20, C09K 11/61, H01L 31/055

(54) **WAVELENGTH CONVERSION MEMBER AND PHOTOVOLTAIC DEVICE USING SAME**

(30) Priority: 09.02.2015 JP 2015022869
(71) Applicant: Panasonic Intellectual Property Management Co., Ltd., Osaka-shi, Osaka 540-6207 (JP)
(72) Inventor: SATO, Natsuki, Osaka-shi, Osaka 540-6207 (JP)
(74) Representative: Müller-Boré & Partner Patentanwälte PartG mbB
(86) International application number: PCT/JP2015/006268
(87) International publication number: WO 2016/129023

(57) **Abstract**

A wavelength conversion member (20) includes a fluoride phosphor (25) activated by Ce³⁺ or Eu²⁺. Then, with regard to the fluoride phosphor, internal quantum efficiency measured at 80 °C is 85% or more when internal quantum efficiency measured at 30 °C is taken as 100%. Moreover, a photovoltaic device includes the above-mentioned wavelength conversion member. The wavelength conversion member uses a fluoride phosphor, in which a decrease of the internal quantum efficiency is suppressed, and excellent temperature characteristics are imparted. Therefore, the wavelength conversion member can effectively utilize ultraviolet light even at high temperature, and it becomes possible to enhance an output of the photovoltaic device.

## Description

### TECHNICAL FIELD

The present invention relates to a wavelength conversion member and a photovoltaic device using the same. More specifically, the present invention relates to a wavelength conversion member that enhances photoelectric conversion efficiency thereof, and to a photovoltaic device using the wavelength conversion member.

### BACKGROUND ART

In general, in a solar cell, photoelectric conversion efficiency of ultraviolet light is lower than photoelectric conversion efficiency of visible light. For example, in the solar cell, in the ultraviolet light in which a wavelength ranges from 300 nm or more to less than 400 nm, the photoelectric conversion efficiency is low, and in the region of the visible light and the infrared light, in which a wavelength ranges from 400 nm or more to less than 1200 nm, the photoelectric conversion efficiency is high. Moreover, such ultraviolet light in which a wavelength stays within a range less than 380 nm is prone to damage the solar cell. Accordingly, in the conventional solar cell, the ultraviolet light in which the wavelength stays within the range less than 380 nm has been cut, for example, by means of a filter.

However, if the ultraviolet light in which the wavelength stays within the range less than 380 nm can be used for power generation, then the photoelectric conversion efficiency of the solar cell is expected to be improved. Therefore, in recent years, in the solar cell, it has been studied not just to cut the ultraviolet light in which the wavelength stays within the range less than 380 nm, but to convert the ultraviolet light into long-wavelength light and to use the long-wavelength light for power generation. Specifically, there has been studied a technology for providing a wavelength conversion layer that converts the ultraviolet light into the visible light or the infrared light.

As a phosphor, which is used for the wavelength conversion layer as described above, and converts the ultraviolet light into the visible light or the infrared light, there is disclosed barium halide in which Eu²⁺ is activated, and specifically, barium fluoride in which Eu²⁺ is activated (for example, refer to Patent Literature 1).

### CITATION LIST

### PATENT LITERATURE

Patent Literature 1: Japanese Unexamined Patent Application Publication No. H02-503717

### SUMMARY OF INVENTION

However, the barium fluoride in which Eu²⁺ is activated exhibits light emission only at low temperature, and hardly exhibits light emission at a temperature of 25°C or more, and accordingly, has not been able to convert the ultraviolet light into the visible light or the infrared light sufficiently. That is, it has been difficult for the wavelength conversion member using the conventional fluoride phosphor to enhance an output of the solar cell at high temperature.

The present invention has been made in consideration of such problems as described above, which are inherent in the prior art. Then, it is an object of the present invention to provide a wavelength conversion member capable of increasing the photoelectric conversion efficiency even at high temperature, and enhancing the output of the solar cell, and to provide a photovoltaic device using the wavelength conversion member.

In order to solve the above-described problems, a wavelength conversion member according to a first aspect of the present invention includes a fluoride phosphor activated by Ce³⁺ or Eu²⁺. Then, with regard to the fluoride phosphor, when internal quantum efficiency measured at 30 °C is taken as 100%, internal quantum efficiency measured at 80 °C is 85% or more.

A photovoltaic device according to a second aspect of the present invention includes the above-mentioned wavelength conversion member.

### BRIEF DESCRIPTION OF DRAWINGS

[Fig. 1] FIG. 1 is a cross-sectional view schematically showing an Example of a solar cell module as a photovoltaic device according to an embodiment of the present invention.
[Fig. 2] FIG. 2 is a graph showing relationships between relative internal quantum efficiency and temperature in phosphors of Example 3 and Comparative Example 1.
[Fig. 3] FIG. 3 is a graph showing an emission spectrum and an excitation spectrum in the phosphor of Example 3.

### DESCRIPTION OF EMBODIMENTS

A description will be made below in detail of a wavelength conversion member and a photovoltaic device according to this embodiment. Note that dimensional ratios in the drawings are exaggerated for convenience of explanation, and are sometimes different from actual ratios.

### [Wavelength conversion member]

The wavelength conversion member according to this embodiment absorbs ultraviolet light in sunlight, and thereafter, converts the ultraviolet light into visible light or infrared light. In this way, the visible light or the infrared light, in which spectral sensitivity is high, increases, and accordingly, it becomes possible to enhance photoelectric conversion efficiency of the solar cell. However, it is necessary for the wavelength conversion member to exhibit high transmittance for the visible light and the infrared light, which are a wavelength region where the solar cell has high sensitivity. This is because, if the transmittance of the solar cell decreases when the wavelength conversion member is provided, then the photoelectric conversion efficiency is lowered due to the decrease of the transmittance rather than enhancement of the photoelectric conversion efficiency by the wavelength conversion member.

Therefore, in order to strike a balance between enhancement of absorption efficiency of the ultraviolet light by the wavelength conversion member and suppression of the decrease in the transmittance of the visible light and the infrared light, the decrease being caused thereby, the wavelength conversion member according to this embodiment includes a fluoride phosphor activated by cerium ions (Ce³⁺) or europium ions (Eu²⁺). The fluoride phosphor is used as the wavelength conversion member, whereby the decrease in the transmittance of the visible light and the infrared light can be suppressed.

Moreover, in the wavelength conversion member in this embodiment, in the fluoride phosphor, when internal quantum efficiency measured at 30 °C is taken as 100%, internal quantum efficiency measured at 80 °C is 85% or more. In this embodiment, a fluoride phosphor having excellent temperature characteristics is used, and accordingly, it becomes possible to sufficiently absorb the ultraviolet light even at high temperature in the summer season, to convert the wavelength thereof, and to enhance the output of the solar cell. Note that, in the fluoride phosphor, when the internal quantum efficiency measured at 30 °C is taken as 100%, the internal quantum efficiency measured at 80 °C is preferably 90% or more, more preferably 95% or more. The fluoride phosphor has so high internal quantum efficiency as described above, whereby such a wavelength conversion member can be obtained, which further enhances the output of the solar cell at high temperature.

Here, it is necessary for the fluoride phosphor to use cerium ions (Ce³⁺) or europium ions (Eu²⁺) as an emission center. Ce³⁺ and Eu²⁺ take the mechanism of light absorption and emission, which are based on 4fₙ↔4fₙ₋₁5d₁ allowed transition. Therefore, wavelengths of the absorption and the light emission are changed depending on host crystals in which these are activated. Hence, Ce³⁺ or Eu²⁺ is used as the emission center, and appropriate host crystals are selected, whereby it becomes possible to convert light in a region from near ultraviolet to violet into light in such a wavelength sensed with high sensitivity by the solar cell. Note that, in the above-mentioned 4fₙ↔4fₙ₋₁5d₁ allowed transition, Ce³⁺ corresponds to n=1, and Eu²⁺ corresponds to n=7.

It is preferable that a host of the fluoride phosphor in this embodiment be a fluoride containing alkaline earth metal and magnesium. That is, it is preferable that the host of the fluoride phosphor be a fluoride containing at least one element selected from the group consisting of calcium (Ca), strontium (Sr) and barium (Ba), and magnesium. This is preferable since high light emission intensity is obtained even at high temperature, and in addition, the quantum efficiency is increased easily. Note that a reason why the light emission intensity at high temperature becomes good is presumed to be as follows. A crystal structure of the fluoride phosphor becomes a strong host crystal in which a large number of [MgF₆]⁴⁻ units with an octahedral structure are bonded to one another while sharing F. Then, a phosphor, which is composed in such a manner that Ce³⁺ or Eu²⁺ as the emission center is substituted for a part of this strong host crystal, has a strong crystal structure, and accordingly, Ce³⁺ or Eu²⁺ becomes hard to vibrate. When Ce³⁺ or Eu²⁺ as the emission center is hard to vibrate, the light emission is stably performed even if the temperature of the phosphor rises. Accordingly, it is presumed that the phosphor composed of the fluoride containing such an alkaline earth metal element and magnesium has good light emission intensity.

Here, as the fluoride phosphor that uses Eu²⁺ as the emission center, CaF₂: Eu²⁺ has been heretofore known. In the case of this phosphor, such a host compound is calcium fluoride (CaF₂), and the emission center is Eu²⁺. Then, CaF₂: Eu²⁺ absorbs ultraviolet light having a wavelength of 300 nm or more to less than 400 nm and emits visible light of approximately 425 nm, and accordingly, can be used as a wavelength conversion material for the solar cell. Moreover, a refractive index of CaF₂ is 1.43, which is approximate to a refractive index of a sealing material to be described later, and accordingly, a wavelength conversion member is obtained, which hardly reduces the transmittance of the visible light and the infrared light even if CaF₂: Eu²⁺ is dispersed in the sealing material.

However, by means of the wavelength conversion member using CaF₂: Eu²⁺, the output of the solar cell cannot be enhanced sufficiently. A reason why the output of the solar cell cannot be enhanced by means of the conventional fluoride phosphor as described above is temperature quenching of the phosphor. The temperature quenching is a phenomenon in which the internal quantum efficiency decreases as the temperature of the phosphor rises. The temperature of the solar cell may rise to 80 °C or more depending on a usage environment. Therefore, when the temperature quenching of the phosphor for use in the wavelength conversion member is conspicuous, then the enhancement of the efficiency by the wavelength conversion cannot be sufficiently obtained under the usage environment where the solar cell gets hot. For example, the internal quantum efficiency of CaF₂: Eu²⁺ at 80 °C decreases to 80% or less of the internal quantum efficiency thereof at 30 °C, and accordingly, the output of the solar cell has not been able to be enhanced sufficiently. Moreover, other conventional fluoride phosphors are conspicuous in temperature quenching, and cannot exhibit at high internal quantum efficiency at 80 °C or more. Therefore, a wavelength conversion member, which is capable of sufficiently enhancing the output of the solar cell, has not been able to be obtained.

In contrast, in the wavelength conversion member in this embodiment, the fluoride phosphor is activated by Ce³⁺ or Eu²⁺, and when the internal quantum efficiency measured at 30 °C is taken as 100%, the internal quantum efficiency measured at 80 °C is 85% or more. Therefore, the wavelength conversion is performed efficiently even under the usage environment where the solar cell gets hot, and it becomes possible to enhance the output of the solar cell. Note that, as far as the inventor of the present invention knows, there is no reported Example of such a fluoride phosphor activated by Ce³⁺ or Eu²⁺, which has small temperature quenching, and it has never been thought that there is a phosphor that strikes a balance between a low refractive index and good temperature quenching characteristics.

Here, in general inorganic phosphors, those using rare earth ions other than Ce³⁺ and Eu²⁺ as the emission center are also known. However, if the emission center is the rare earth ions other than Ce³⁺ and Eu²⁺, even if a composition of the host crystal is adjusted, it is difficult to obtain an inorganic phosphor that absorbs the ultraviolet light having a wavelength of 300 to 400 nm. However, when at least one of Ce³⁺ and Eu²⁺ is contained, the composition of the host crystal is adjusted, whereby it becomes possible to obtain the inorganic phosphor that absorbs the ultraviolet light having a wavelength of 300 to 400 nm. A main reason for this is presumed as follows.

Among the rare earth ions, rare earth ions of Ce to Yb have electrons in a 4f orbital. The absorption and emission of light, which are derived from the rare earth ions, are classified into two types, which are: transition in a 4f shell; and transition between a 5d shell and the 4f shell.

The ions other than Ce³⁺ and Eu²⁺ among the rare earth ions generally absorb and emit light by the transition in the 4f shell. However, in the transition in the 4f shell, the electrons in the 4f orbital are present in an inside of electrons in a 5s orbital and a 5p orbital, and are shielded, and accordingly, fluctuation of an energy level due to a surrounding influence are less likely to occur. Therefore, in the inorganic phosphor that uses the ions other than Ce³⁺ and Eu²⁺ as the emission center, even if the composition of the host crystal is adjusted, the change of the light emission wavelength is small, and it is difficult to obtain the inorganic phosphor that absorbs the ultraviolet light having a wavelength of 300 to 400 nm.

In contrast, Ce³⁺ and Eu²⁺ perform the absorption and emission of light by the transition between the 5d shell and the 4f shell, that is, transition between 4fⁿ and 4fⁿ⁻¹5d. In this transition between the 5d shell and the 4f shell, the 5d orbital is not shielded from other orbits, and accordingly, the fluctuation of the energy level of the 5d orbital due to the surrounding influence is likely to occur. Therefore, in the inorganic phosphor that uses Ce³⁺ and Eu²⁺ as the emission center, in the case of light emission that is based on the transition from the 4fⁿ⁻¹5d¹ level to the 4f orbital, it becomes possible to greatly change the light emission wavelength by adjusting the composition of the host crystal. Due to this great change of the light emission wavelength, in accordance with the inorganic phosphor that uses Ce³⁺ and Eu²⁺ as the emission center, it becomes possible to obtain the inorganic phosphor, which absorbs the ultraviolet light having a wavelength of 300 to 400 nm.

In the wavelength conversion member of this embodiment, it is preferable that the fluoride phosphor include a compound, which is represented by General formula (1), as the host. In this way, a fluoride phosphor can be obtained, which is excellent in absorption rate of the ultraviolet light, quantum efficiency and temperature characteristics. Note that, in General formula (1), it is preferable that the alkaline earth metal be at least one element selected from the group consisting of calcium (Ca), strontium (Sr) and barium (Ba):

M₃Mg₄F₁₄ (1)

(where M is alkaline earth metal).

Note that a crystal structure, in which one of Ce³⁺ and Eu²⁺ is substituted for a part of atoms of the host crystal having the composition represented by General formula (1), is represented, for example, by Chemical formula (2) or (3):

(M₁₋ₓCeₓ)₃Mg₄F₁₄ (2)

(where M is at least one alkaline earth metal selected from the group consisting of Ca, Sr and Ba, and x satisfies 0 < x < 0.3.).

(M_{1-y}Eu_{y})₃Mg₄F₁₄ (3)

(where M is at least one alkaline earth metal selected from the group consisting of Ca, Sr and Ba, and y satisfies 0 < y < 0.3.).

In Chemical formula (2), x is preferably 0.003 ≤ x ≤ 0.1, more preferably 0.01 ≤ x ≤ 0.1. Moreover, in Chemical formula (3), y is preferably 0.003 ≤ y ≤ 0.1, more preferably 0.01 ≤ y ≤ 0.1.

Moreover, the fluoride phosphor may contain alkaline metal. This makes it possible to control an excitation spectrum and an emission spectrum, which are derived from Eu²⁺ and Ce³⁺. Note that, preferably, the alkaline metal is at least one element selected from the group consisting of lithium (Li), sodium (Na), potassium (K), rubidium (Rb) and cesium (Cs).

The fluoride phosphor may contain a halogen element other than fluorine within a range where the crystal structure of the fluoride phosphor is not damaged. This makes it possible to control the excitation spectrum and the emission spectrum, which are derived from Eu²⁺ and Ce³⁺, and in addition, to control the refractive index of the phosphor. Note that, preferably, the halogen element is at least one element selected from the group consisting of chlorine (Cl), bromine (Br) and iodine (I).

The fluoride phosphor may contain manganese ions (Mn²⁺). In this way, energy is transferred from Eu²⁺ or Ce³⁺ to Mn²⁺, and it becomes possible for Mn²⁺ to serve as the emission center and to emit light on the long wavelength side. Moreover, the fluoride phosphor may contain oxygen within the range where the crystal structure of the fluoride phosphor is not damaged. This makes it possible to control the refractive index of the phosphor.

Moreover, the fluoride phosphor may contain a rare earth element other than the element serving as the emission center. The fluoride phosphor contains the rare earth element, whereby a large amount of the element serving as the emission center can be contained, and it becomes possible to enhance the absorption rate of the ultraviolet light. Note that, preferably, the rare earth element is at least one element selected from the group consisting of scandium (Sc), yttrium (Y), lanthanum (La), praseodymium (Pr), neodymium (Nd), promethium (Pm), samarium (Sm), gadolinium (Gd), terbium (Tb), dysprosium (Dy), holmium (Ho), erbium (Er), thulium (Tm), ytterbium (Yb), and lutetium (Lu).

The fluoride phosphor may contain an element capable of taking a hexacoordinated state, the element being other than Mg. The fluoride phosphor contains such an element as described above, whereby it becomes possible to control the refractive index of the phosphor. Note that, preferably, the element capable of taking the hexacoordinated state is, for example, at least one element selected from the group consisting of aluminum (Al), gallium (Ga), scandium (Sc), zirconium (Zr), manganese (Mn) and lutetium (Lu).

It is preferable that the fluoride phosphor have the same crystal structure as Pb₃Nb₄O₁₂F₂. In this way, the fluoride phosphor can be obtained, which is excellent in absorption rate, quantum efficiency and temperature characteristics.

Moreover, it is preferable that the fluoride phosphor include a compound, which is represented by Chemical formula (4), as the host. In this way, the fluoride phosphor can be obtained, which is excellent in absorption rate, quantum efficiency and temperature characteristics. Moreover, it becomes possible to adjust the refractive index of the fluoride phosphor:

Ba₂(Ca₁₋ₓSrₓ)Mg₄F₁₄ (4)

(where 0 ≤ x ≤ 1.).

It is also preferable that the fluoride phosphor include a compound, which is represented by Chemical formula (5), as the host. This makes it possible to adjust the refractive index of the fluoride phosphor:

Ba_{2+y}(Ca₁₋ₓSrₓ)_{1-y}Mg₄F₁₄ (5)

(where0≤x≤1,0≤y≤1).

In the wavelength conversion member of this embodiment, a central particle size (D₅₀) of the fluoride phosphor is preferably 0.1 µm or more to less than 100 µm, and more preferably 0.3 µm or more to less than 30 µm. The central particle size of the phosphor stays within this range, whereby it becomes possible to obtain such a wavelength conversion member that sufficiently absorbs the ultraviolet light in the sunlight and suppresses the decrease of the transmittance of the visible light and the infrared light. Note that the central particle size of the fluoride phosphor can be measured, for example, by a laser diffraction/scattering-type particle size distribution measurement apparatus.

Moreover, an average particle size of the fluoride phosphor is preferably 0.1 µm or more to less than 100 µm, and more preferably 0.3 µm or more to less than 30 µm. The average particle size of the fluoride phosphor stays within this range, whereby it becomes possible to obtain such a wavelength conversion member that sufficiently absorbs the ultraviolet light in the sunlight and suppresses the decrease of the transmittance of the visible light and the infrared light. Note that the average particle size of the fluoride phosphor is defined as an average value of longest axis lengths in arbitrary 20 or more phosphor particles observed by a scanning electron microscope.

It is preferable that the light emission wavelength of the fluoride phosphor be 440 nm or more. In this way, the ultraviolet light can be converted into a region where the spectral sensitivity of the solar cell is high, and accordingly, it becomes possible to greatly enhance the output of the solar cell.

The refractive index of the fluoride phosphor is preferably 1.41 or more to less than 1.57, more preferably 1.44 or more to less than 1.54, and particularly preferably 1.47 or more to less than 1.51. In this way, when the fluoride phosphor is dispersed in the sealing material as described later, it becomes possible to suppress the decrease of the transmittance of the visible light and the infrared light.

It is preferable that the wavelength conversion member of this embodiment further include the sealing material that disperses the fluoride phosphor therein. That is, in the wavelength conversion member, it is preferable that the fluoride phosphor be dispersed in the sealing material. The fluoride phosphor is dispersed in the sealing material, whereby it becomes possible to sufficiently absorb the ultraviolet light, and to perform the wavelength conversion for the visible light or the infrared light. Furthermore, it becomes easy to form the wavelength conversion member into a sheet shape or a film shape, and it becomes possible to dispose the wavelength conversion member on the solar cell with ease.

As the sealing material, for example, there can be used at least one resin material selected from the group consisting of an ethylene-vinyl acetate copolymer (EVA), polyvinyl butyral (PVB), polyimide, polyethylene, polypropylene, and polyethylene terephthalate (PET). Note that refractive indices of these resins are 1.41 or more to less than 1.57.

Here, when the wavelength conversion member has a configuration in which the fluoride phosphor is dispersed in the sealing material, then in order not to lower the transmittance of the visible light and the infrared light, it is preferable that such a particle size of the phosphor be reduced to approximately several tens of nanometers, or that the refractive index of the phosphor be approximately the same as that of the sealing material. However, as the particle size of the phosphor is larger, a defect density in the phosphor is reduced, and an energy loss during the light emission is reduced, and accordingly, light emission efficiency is increased. Hence, in order not to lower the transmittance of the visible light and the infrared light, it is preferable that, in the wavelength conversion member of this embodiment, the refractive index of the phosphor be approximately the same as that of the sealing material. Specifically, as described above, the refractive index of the fluoride phosphor is preferably 1.41 or more to less than 1.57.

Herein, the inorganic phosphor is used for a variety of light emitting devices, and is used for, for example, a fluorescent lamp, an electron tube, a plasma display panel (PDP), a white LED, and the like. In general, the inorganic phosphor is a compound in which an element that can become fluorescence-emitting ions is substituted for a part of a crystalline compound. As mentioned above, the ions having such characteristics are called "emission center". Then, the ions serving as the emission center are introduced into the host serving as the crystalline compound. As the host of the phosphor for use in such an application, there are mentioned oxides, nitrides, sulfides, oxynitrides, oxysulfides, acid halides, and the like. In general, a refractive index of each of these compounds serving as the hosts is 1.6 or more, which is higher than that of the sealing material. Therefore, in the wavelength conversion member in which the phosphor composed of the host as described above is dispersed in the sealing material, the visible light and the infrared light are reflected due to a difference in refractive index between the sealing material and the phosphor, and this reflection has caused a deterioration of the photoelectric conversion efficiency due to the decrease of the transmittance.

In contrast, the wavelength conversion member of this embodiment employs the fluoride phosphor as the phosphor. In the fluoride phosphor, a fluoride having a refractive index as low as that of the sealing material is the host compound. Therefore, since the difference in refractive index between the sealing material and the phosphor is small, the reflection of the visible light and the infrared light is reduced in the wavelength conversion member, and it becomes possible to suppress the deterioration of the photoelectric conversion efficiency, which is caused by the decrease of the transmittance.

In the wavelength conversion member of this embodiment, a content of the fluoride phosphor in the sealing material is preferably 0.1 % by volume or more to less than 10 % by volume, more preferably 1 % by volume or more to less than 5 % by volume. This makes it possible to obtain such a wavelength conversion member that sufficiently absorbs the ultraviolet light and suppresses the decrease of the transmittance of the visible light and the infrared light.

The fluoride phosphor in the wavelength conversion member of this embodiment can be produced by a publicly known method. Specifically, like yttrium aluminum garnet (YAG), the fluoride phosphor can be synthesized by using a publicly known solid phase reaction.

Specifically, first, a fluoride of an alkaline earth metal element, a fluoride of a rare earth element, and a fluoride of magnesium are prepared. Next, raw material powders are blended so as to have a stoichiometric composition of a desired compound or a composition close to the stoichiometric composition, and are mixed thoroughly by using a mortar, a ball mill or the like. Thereafter, such a mixed raw material is baked by an electric furnace or the like while using a baking vessel such as an alumina crucible, whereby the fluoride phosphor of this embodiment can be prepared. Note that, when the mixed raw material is baked, it is preferable to heat the mixed raw material at a baking temperature of 700 to 1000 °C for several hours in the atmosphere or a weakly reductive atmosphere. Moreover, an additive such as a reaction accelerator may be added to the raw materials. For example, ammonium fluoride (NH₄F) is preferable since the ammonium fluoride suppresses desorption of fluorine.

Then, the wavelength conversion member of this embodiment can be obtained by mixing the phosphor, which is obtained as described above, with the sealing material, and by molding an obtained mixture into a sheet form, a film form, a plate form, or the like. Note that, though a thickness of the wavelength conversion member is not particularly limited, it is preferable to set the thickness, for example, to 200 µm to 1000 µm.

As described above, the wavelength conversion member according to this embodiment includes the fluoride phosphor activated by Ce³⁺ or Eu²⁺. Then, in the fluoride phosphor, when the internal quantum efficiency measured at 30 °C is taken as 100%, the internal quantum efficiency measured at 80 °C is 85% or more. Then, it has been found out that some fluoride phosphors are excellent in temperature quenching as a result of examining in detail such Ce³⁺ or Eu²⁺-activated fluoride phosphors heretofore considered to have large temperature quenching, and consequently, this embodiment can be achieved. Therefore, in the wavelength conversion member, the ultraviolet light can be sufficiently subjected to the wavelength conversion without lowering the transmittance of the visible light or the infrared light, and it becomes possible to sufficiently enhance the output of the photovoltaic device even at high temperature.

### [Photovoltaic device]

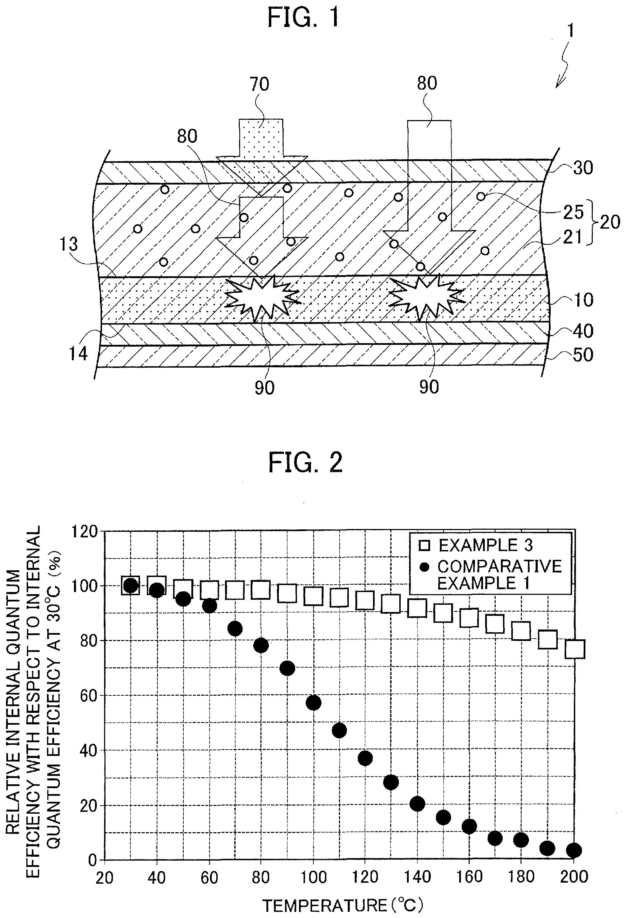

Next, a description will be made of the photovoltaic device according to this embodiment. The photovoltaic device according to this embodiment includes the above-mentioned wavelength conversion member. Specifically, as the photovoltaic device according to this embodiment, a solar cell module 1 as shown in FIG. 1 can be mentioned as the photovoltaic device according to this embodiment.

As shown in FIG. 1, the solar cell module 1 includes: a solar cell 10 as a photoelectric conversion element; a wavelength conversion member 20 disposed on a light receiving surface 13 side of the solar cell 10; and a surface protection layer 30 disposed on a surface of the wavelength conversion member 20. The solar cell module 1 further includes: a back surface sealing member 40 disposed on a back surface 14 that is a surface opposite with the light receiving surface 13 of the solar cell 10; and a back surface protection layer 50 disposed on a back surface of the back surface sealing member 40. That is, the solar cell module 1 has a configuration in which the surface protection layer 30, the wavelength conversion member 20, the solar cell 10, the back surface sealing member 40 and the back surface protection layer 50 are provided in this order from above in the drawing.

The solar cell 10 absorbs light made incident from the light receiving surface 13 of the solar cell 10, and generates photovoltaic power. The solar cell 10 is formed, for example, by using a semiconductor material such as crystalline silicon, gallium arsenide (GaAs), indium phosphide (InP), or the like. Specifically, the solar cell 10 is formed, for example, by laminating the crystalline silicon and amorphous silicon. Electrodes (not shown) are provided on the light receiving surface 13 of the solar cell 10 and on the back surface 14 that is the surface opposite with the light receiving surface 13. The photovoltaic power generated in the solar cell 10 is supplied to the outside via the electrodes.

The wavelength conversion member 20 is disposed on the light receiving surface 13 of the solar cell 10. As shown in FIG. 1, the wavelength conversion member 20 includes: a sealing material 21 that seals the light receiving surface 13 of the solar cell 10; and a fluoride phosphor 25 dispersed in the sealing material 21. The wavelength conversion member 20 prevents moisture from entering the solar cell 10 by the sealing material 21, and enhances strength of the entire solar cell module 1.

The surface protection layer 30 is provided on the light receiving surface 13 side of the solar cell 10, protects the solar cell 10 from the external environment, and in addition, transmits therethrough light to be absorbed by the solar cell 10. For the surface protection layer 30, for example, a glass substrate can be used. Note that, besides the glass substrate, the surface protection layer 30 may be polycarbonate, acrylic resin, polyester and polyethylene fluoride. The back surface protection layer 50 is a back sheet provided on the back surface 14 side of the solar cell 10. The back surface protection layer 50 may be the same transparent substrate as the surface protection layer 30, such as glass and plastic.

The back surface sealing member 40 is disposed on the back surface 14 of the solar cell 10, prevents moisture from entering the solar cell 10, and enhances the strength of the entire solar cell module 1. The back surface sealing member 40 is made, for example, of the same material as such a material that can be used for the sealing material 21 of the wavelength conversion member 20. The material of the back surface sealing member 40 may be the same as or different from the material of the sealing material 21 of the wavelength conversion member 20.

Moreover, metal foil or the like may be provided between the back surface sealing member 40 and the back surface protection layer 50 so that the light made incident from the surface protection layer 30 side can be absorbed more by the solar cell 10. In this way, the light that has reached the back surface protection layer 50 from the surface protection layer 30 can be reflected toward the solar cell 10.

When the solar cell module 1 is irradiated with sunlight including ultraviolet light 70, visible light and infrared light 80, the ultraviolet light 70, the visible light and the infrared light 80 pass through the surface protection layer 30, and is made incident onto the wavelength conversion member 20. The visible light and the infrared light 80 made incident onto the wavelength conversion member 20 pass as they are through the wavelength conversion member 20 without being converted substantially by the fluoride phosphor 25, and then are applied to the solar cell 10. Meanwhile, the ultraviolet light 70 made incident onto the wavelength conversion member 20 is converted into the visible light and the infrared light 80, which are light on the long wavelength side, by the fluoride phosphor 25, and thereafter, are applied to the solar cell 10. The solar cell 10 generates photovoltaic power 90 by the applied visible light and infrared light 80, and the photovoltaic power 90 is supplied to the outside of the solar cell module 1 via the terminals which are not shown.

As mentioned above, in the wavelength conversion member 20 of this embodiment, the fluoride phosphor 25 is used, in which the decrease of the internal quantum efficiency at high temperature is greatly suppressed, and excellent temperature characteristics are imparted. Therefore, the ultraviolet light can be effectively utilized without lowering the transmittance in the visible light or the infrared light, and it becomes possible to enhance the output of the solar cell module 1 even at high temperature.

### EXAMPLES

Hereinafter, this embodiment will be described more in detail by Examples and Comparative Examples; however, this embodiment is not limited to these Examples.

### [Examples 1 to 16 and Comparative Example 1]

### (Preparation of phosphor)

Fluoride phosphors of Examples 1 to 16 and Comparative Example 1 were synthesized by using a preparation method that utilizes the solid phase reaction, and characteristics thereof were evaluated. Note that, in these Examples and Comparative Example, the following compound powders were used as raw materials.

Barium fluoride (BaF₂): purity 3N, made by Wako Pure Chemical Industries, Ltd.

Strontium fluoride (SrF₂): purity 2N5, made by Wako Pure Chemical Industries, Ltd.

Calcium fluoride (CaF₂): purity 3N, made by Kojundo Chemical Laboratory Co., Ltd.

Magnesium fluoride (MgF₂): purity 2N, made by Wako Pure Chemical Industries, Ltd.

Europium fluoride (EuF₃): purity 3N, made by Wako Pure Chemical Industries, Ltd.

Regarding Examples 1 to 16, first, the respective raw materials were weighed at ratios shown in Table 1. Next, the raw materials were thoroughly dry-blended by using a magnetic mortar and a magnetic pestle, and each of baking raw materials was obtained. Thereafter, the baking raw material was transferred to an alumina crucible, and was baked for 2 hours in a reducing atmosphere (in a mixed gas atmosphere of 96% nitrogen and 4% hydrogen) at a temperature of 850 °C by using a tubular atmosphere furnace. Thereafter, a baked product thus obtained was disintegrated by using the alumina mortar and the alumina pestle, whereby each of the phosphors of Examples 1 to 16 was obtained.

Note that, when each of the obtained phosphors of Examples 1 to 16 was irradiated with ultraviolet rays (wavelength: 365 nm), blue fluorescence was visually observed in each case.

Regarding Comparative Example 1, first, the respective raw materials were weighed at a ratio shown in Table 1. Next, the raw materials were thoroughly dry-blended by using the magnetic mortar and the magnetic pestle, and a baking raw material was obtained. Thereafter, the baking raw material was transferred to the alumina crucible, and was baked for 2 hours in the reducing atmosphere (in the mixed gas atmosphere of 96% nitrogen and 4% hydrogen) at a temperature of 1200 °C by using the tubular atmosphere furnace. Thereafter, a baked product thus obtained was disintegrated by using the alumina mortar and the alumina pestle, whereby the phosphor of Comparative Example 1 was obtained.

Note that, when the obtained phosphor of Comparative Example 1 was irradiated with the ultraviolet rays (wavelength: 365 nm), bluish purple fluorescence was visually observed.

**[Table 1]**

| | Composition | BaF₂ (g) | SrF₂ (g) | CaF₂ (g) | MgF₂ (g) | EuF₃ (g) |
|---|---|---|---|---|---|---|
| Example 1 | (Ba_{2.191}Ca_{0.8}Eu_{0.009})Mg₄F₁₄ | 1.921 | 0.000 | 0.312 | 1.246 | 0.009 |
| Example 2 | (Ba_{2.17}Ca_{0.8}Eu_{0.03})Mg₄F₁₄ | 1.902 | 0.000 | 0.312 | 1.246 | 0.031 |
| Example 3 | (Ba_{2.11}Ca_{0.8}Eu_{0.09})Mg₄F₁₄ | 1.850 | 0.000 | 0.312 | 1.246 | 0.094 |
| Example 4 | (Ba_{2.05}Ca_{0.8}Eu_{0.15})Mg₄F₁₄ | 1.797 | 0.000 | 0.312 | 1.246 | 0.157 |
| Example 5 | (Ba_{1.99}Ca_{0.8}Eu_{0.21})Mg₄F₁₄ | 1.745 | 0.000 | 0.312 | 1.246 | 0.219 |
| Example 6 | (Ba_{1.9}Ca_{0.8}Eu_{0.3})Mg₄F₁₄ | 1.666 | 0.000 | 0.312 | 1.246 | 0.313 |
| Example 7 | Ba_{2.21}Ca_{0.7}Eu_{0.09}Mg₄F₁₄ | 1.937 | 0.000 | 0.273 | 1.246 | 0.094 |
| Example 8 | Ba_{2.01}Ca_{0.9}Eu_{0.09}Mg₄F₁₄ | 1.762 | 0.000 | 0.351 | 1.246 | 0.094 |
| Example 9 | Ba_{1.94}Ca_{0.97}Eu_{0.09}Mg₄F₁₄ | 1.701 | 0.000 | 0.379 | 1.246 | 0.094 |
| Example 10 | Ba_{1.91}CaEu_{0.09}Mg₄F₁₄ | 1.674 | 0.000 | 0.390 | 1.246 | 0.094 |
| Example 11 | Ba_{2.01}Sr_{0.1}Ca_{0.8}Eu_{0.09}Mg₄F₁₄ | 1.762 | 0.063 | 0.312 | 1.246 | 0.094 |
| Example 12 | Ba_{1.81}Sr_{0.3}Ca_{0.8}Eu_{0.09}Mg₄F₁₄ | 1.587 | 0.188 | 0.312 | 1.246 | 0.094 |
| Example 13 | Ba_{1.61}Sr_{0.5}Ca_{0.8}Eu_{0.09}Mg₄F₁₄ | 1.411 | 0.314 | 0.312 | 1.246 | 0.094 |
| Example 14 | Ba_{2.11}Ca_{0.7}Sr_{0.1}Eu_{0.09}Mg₄F₁₄ | 1.850 | 0.063 | 0.273 | 1.246 | 0.094 |
| Example 15 | Ba_{2.11}Ca_{0.5}Sr_{0.3}Eu_{0.09}Mg₄F₁₄ | 1.850 | 0.188 | 0.195 | 1.246 | 0.094 |
| Example 16 | Ba_{2.11}Ca_{0.3}Sr_{0.5}Eu_{0.09}Mg₄F₁₄ | 1.850 | 0.314 | 0.117 | 1.246 | 0.094 |
| Comparative example 1 | Ca_{0.997}Eu_{0.003}F₂ | 0.000 | 0.000 | 7.784 | 0.000 | 0.063 |

### (Evaluation)

### <Internal quantum efficiency>

The internal quantum efficiency of each of the phosphors obtained in Examples 1 to 16 and Comparative Example 1 was measured. The quantum efficiency of each of the phosphors was measured by using the quantum efficiency measurement system QE-1100 manufactured by Otsuka Electronics Co., Ltd. Measurement and analysis conditions are as follows.
Excitation wavelength: 350 nm
Number of integrations: 30 times
Exposure time: automatic
Measurement temperature range: 30 °C to 200°C
Measurement temperature step: 10 °C
Excitation light wavelength range: ±20 nm
Fluorescence wavelength range: 370 nm to 800 nm

FIG. 2 is a graph showing relative internal quantum efficiency at each temperature when the internal quantum efficiency at 30 °C is taken as 100% for the phosphors of Example 3 and Comparative Example 1. As shown in FIG. 2, it is understood that the phosphor of Example 3 exhibits high internal quantum efficiency with respect to the phosphor of Comparative Example 1 even at high temperature. Specifically, the relative internal quantum efficiency of the phosphor of Comparative Example 1 at 80 °C is 80% or less, whereas the relative internal quantum efficiency of the phosphor of Example 3 at 80 °C is 98%. Moreover, even when the temperature of the phosphor of Example 3 rose, the phosphor of Example 3 exhibited high relative internal quantum efficiency, which is 96% at 100 °C and 89% at 150 °C.

Table 2 shows relative internal quantum efficiency at 80 °C with respect to the internal quantum efficiency at 30 °C ([internal quantum efficiency at 80 °C] / [internal quantum efficiency at 30 °C] × 100) in each of the phosphors of Examples 1 to 16 and Comparative Example 1. Moreover, Table 2 also shows an emission peak wavelength when each of the phosphors of Examples 1 to 16 and Comparative Example 1 was excited at 350 nm.

As shown in Table 2, each of the phosphors of Examples 1 to 16 exhibited light emission in a visible light region of 400 nm or more. Moreover, in each of the phosphors of Examples 1 to 16, the relative internal quantum efficiency at 80 °C with respect to the internal quantum efficiency at 30 °C was 95% or more, and each of the phosphors exhibited superior temperature characteristics to those of the phosphor of Comparative Example 1.

**[Table 2]**

| | Composition | Emission peak wavelength (nm) | Relative internal quantum efficiency at 80°C with respect to internal quantum efficiency at 30°C (%) |
|---|---|---|---|
| Example 1 | (Ba_{2.191}Ca_{0.8}Eu_{0.009})Mg₄F₁₄ | 420 | 99 |
| Example 2 | (Ba_{2.17}Ca_{0.8}Eu_{0.03})Mg₄F₁₄ | 448 | 97 |
| Example 3 | (Ba_{2.11}Ca_{0.8}Eu_{0.09})Mg₄F₁₄ | 458 | 98 |
| Example 4 | (Ba_{2.05}Ca_{0.8}Eu_{0.15})Mg₄F₁₄ | 460 | 98 |
| Example 5 | (Ba_{1.99}Ca_{0.8}Eu_{0.21})Mg₄F₁₄ | 460 | 98 |
| Example 6 | (Ba_{1.9}Ca_{0.8}Eu_{0.3})Mg₄F₁₄ | 457 | 98 |
| Example 7 | Ba_{2.21}Ca_{0.7}Eu_{0.09}Mg₄F₁₄ | 460 | 97 |
| Example 8 | Ba_{2.01}Ca_{0.9}Eu_{0.09}Mg₄F₁₄ | 456 | 98 |
| Example 9 | Ba_{1.94}Ca_{0.97}Eu_{0.09}Mg₄F₁₄ | 455 | 97 |
| Example 10 | Ba_{1.91}CaEu_{0.09}Mg₄F₁₄ | 456 | 97 |
| Example 11 | Ba_{2.01}Sr_{0.1}Ca_{0.8}Eu_{0.09}Mg₄F₁₄ | 450 | 97 |
| Example 12 | Ba_{1.81}Sr_{0.3}Ca_{0.8}Eu_{0.09}Mg₄F₁₄ | 441 | 97 |
| Example 13 | Ba_{1.61}Sr_{0.5}Ca_{0.8}Eu_{0.09}Mg₄F₁₄ | 436 | 98 |
| Example 14 | Ba_{2.11}Ca_{0.7}Sr_{0.1}Eu_{0.09}Mg₄F₁₄ | 455 | 96 |
| Example 15 | Ba_{2.11}Ca_{0.5}Sr_{0.3}Eu_{0.09}Mg₄F₁₄ | 450 | 98 |
| Example 16 | Ba_{2.11} Ca_{0.3}Sr_{0.5}Eu_{0.09}Mg₄F₁₄ | 444 | 99 |
| Comparative example 1 | Ca_{0.997}Eu_{0.003}F₂ | 427 | 80 |

### <Excitation characteristics and Light emission characteristics>

Excitation and light emission characteristics of the phosphor of Example 3 were evaluated. Specifically, an excitation spectrum and an emission spectrum were measured by using the spectrofluorometer (FP-6500) manufactured by JASCO Corporation. Note that an excitation wavelength at the time of measuring the emission spectrum was set to 350 nm, and a monitoring wavelength at the time of measuring the excitation spectrum was set to an emission peak wavelength (458 nm).

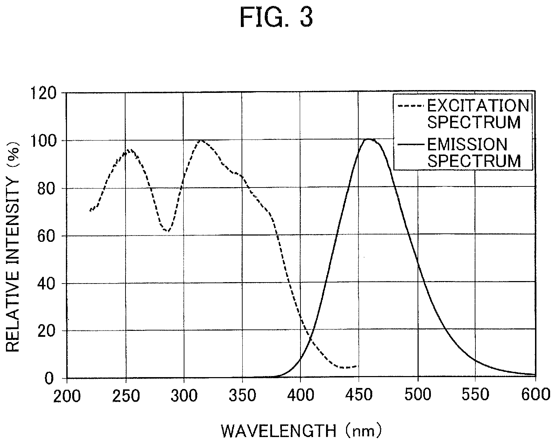

As shown in FIG. 3, it is understood that the phosphor of Example 3 absorbs the ultraviolet light having a wavelength of 300 nm or more to less than 400 nm, and exhibits light emission having a peak at 458 nm.

### <Refractive index>

Refractive indices of the phosphors of Example 3 and Comparative Example 1 were measured. The refractive indices of the phosphors were measured by the Becke line test (according to JIS K 7142 B method) by using the Abbe refractometer NAR-2T manufactured by Atago Co., Ltd. and the polarizing microscope BH-2 manufactured by Olympus Corporation. Measurement conditions are as follows.
Immersion liquid: propylene carbonate (n_{D}²³ 1.420)
   butyl phthalate (n_{D}²³ 1.491)
Temperature: 23 °C
Light source: Na (D line/589 nm)

As a result of the measurement, the refractive index of the phosphor of Example 3 was 1.45, and the refractive index of the phosphor of Comparative Example 1 was 1.44. As described above, it is understood that the refractive index of the phosphor of Example 3 stays within a range of 1.41 or more to less than 1.57, and is close to the refractive index of the sealing material.

### [Example 17]

A wavelength conversion member was produced by using the phosphor of Example 3 and an ethylene-vinyl acetate copolymer (EVA) as the sealing material. Specifically, the phosphor and the ethylene-vinyl acetate copolymer were weighed at ratios shown in Table 3. As the ethylene-vinyl acetate copolymer, Evaflex (registered trademark) EV450 manufactured by Mitsui-Dupont Polychemicals Co., Ltd. was used.

Next, a mixture of the phosphor and the ethylene-vinyl acetate copolymer was obtained by melt-kneading using the plastomill manufactured by Toyo Seiki Seisaku-sho, Ltd. at a heating temperature of 150 °C and a number of revolutions of 30 rpm for 30 minutes. Then, the obtained mixture was subjected to hot press by a hot press machine at a heating temperature of 150 °C and a pressing pressure of 1.5 MPa, whereby a sheet-shaped wavelength conversion member having a thickness of 0.6 mm was obtained.

### [Comparative Example 2]

A wavelength conversion member of this Example was obtained in the same manner as in Example 17 except that a BAM phosphor (BaMgAl₁₀O₁₇: Eu²⁺) was used as the phosphor.

**[Table 3]**

| | Phosphor | | Sealing material | | Transmittance (%) |
|---|---|---|---|---|---|
| | Type | Blending quantity (g) | Type | Blending quantity (g) | |
| Example 17 | Example 3 | 11 | EVA | 46 | 81 |
| Comparative example 2 | BAM | 11 | EVA | 46 | 42 |

Transmittance of each of the wavelength conversion members obtained in Example 17 and Comparative Example 2 was measured. The transmittance was measured by using the ultraviolet-visible-near infrared spectrophotometer UV-2600 manufactured by Shimadzu Corporation. Measurement conditions are as follows.
Measurement range: 300 to 800 nm
Scan speed: 600 nm/min
Sampling interval: 1 nm
Slit width: 2 nm
Light source switching wavelength: 340 nm
Light source (300 - 340 nm): deuterium lamp
Light source (340 - 800 nm): tungsten halogen lamp

Table 3 also shows the transmittance of light of 590 nm in the wavelength conversion members of Example 17 and Comparative Example 2. Note that the refractive index of the BAM phosphor is 1.77.

As shown in Table 3, the wavelength conversion member of Example 17, which used the phosphor of Example 3 exhibited a high transmittance of 81%. Meanwhile, the wavelength conversion member of Comparative Example 2, which used the BAM phosphor, had a low transmittance of 42%. This is because the refractive index of the phosphor of Example 3 is 1.45, which is close to the refractive index (1.48) of the EVA, and the refractive index of the BAM phosphor is 1.77, which is greatly different from the refractive index of the EVA. That is, in the case of the BAM phosphor, since the difference in refractive index from the sealing material was large, the light that hit phosphor particles was scattered, and the transmittance decreased. Meanwhile, in the case of the phosphor of Example 3, the difference in refractive index from the sealing material was small, and light scattering was suppressed, and accordingly, high transmittance was exhibited.

The entire contents of Japanese Patent Application No. 2015-022869 (filed on: February 9, 2015) is incorporated herein by reference.

Although the present invention has been described above by reference to the embodiments and the Example, the present invention is not limited to those, and it will be apparent to these skilled in the art that various modifications and improvements can be made.

### INDUSTRIAL APPLICABILITY

The wavelength conversion member of the present invention uses the fluoride phosphor, in which the decrease of the internal quantum efficiency is suppressed, and excellent temperature characteristics are imparted. Therefore, it is possible to effectively utilize the ultraviolet light even at high temperature, and it becomes possible to enhance the output of the photovoltaic device.

### REFERENCE SIGNS LIST

- 1: SOLAR CELL MODULE (PHOTOVOLTAIC DEVICE)
- 20: WAVELENGTH CONVERSION MEMBER
- 21: SEALING MATERIAL
- 25: FLUORIDE PHOSPHOR

## Claims

1. A wavelength conversion member comprising:
a fluoride phosphor activated by Ce³⁺ or Eu²⁺,
wherein, with regard to the fluoride phosphor, internal quantum efficiency measured at 80 °C is 85% or more when internal quantum efficiency measured at 30 °C is taken as 100%.

2. The wavelength conversion member according to claim 1, wherein a host of the fluoride phosphor is a fluoride containing alkaline earth metal and magnesium.

3. The wavelength conversion member according to claim 1 or 2, wherein the fluoride phosphor comprises, as a host, a compound represented by a general formula: M₃Mg₄F₁₄ (where M is alkaline earth metal).

4. The wavelength conversion member according to any one of claims 1 to 3, wherein a refractive index of the fluoride phosphor is 1.41 or more to less than 1.57.

5. The wavelength conversion member according to any one of claims 1 to 4, further comprising a sealing material which disperses the fluoride phosphor.

6. A photovoltaic device comprising the wavelength conversion member according to any one of claims 1 to 5.
